# EUROPÄISCHE PATENTSCHRIFT

(11) **EP 2 278 713 B1**
(45) Veröffentlichungstag und Bekanntmachung des Hinweises auf die Patenterteilung: **28.01.2015**
(21) Anmeldenummer: 10167299.6
(22) Anmeldetag: 25.06.2010
(51) Int. Cl.: H03K 17/955, H03K 17/96, G01V 3/08

(54) **Kapazitive Sensoranordnung mit einer Sensorelektrode, einer Schirmelektrode und einer Hintergrundelektrode**
Capacitative sensor assembly with a sensor electrode, a shielding electrode and a background electrode
Agencement de capteur capacitif doté d'une électrode de capteur, d'une électrode écran et d'une électrode d'arrière-plan

(30) Priorität: 03.07.2009 DE 102009031824
(43) Veröffentlichungstag der Anmeldung: 26.01.2011
(73) Patentinhaber: Huf Hülsbeck & Fürst GmbH & Co. KG, 42551 Velbert (DE)
(72) Erfinder: Van Gastel, Peter, 42699 Solingen (DE)
(74) Vertreter: Zenz

(56) Entgegenhaltungen:
- GB-A- 2 404 443
- US-A1- 2008 042 660
- US-B1- 6 445 294

## Beschreibung

Die Erfindung bezieht sich auf eine kapazitive Sensoranordnung mit einer Sensorelektrode, mit deren Hilfe das Eindringen eines Objekts in einen Raum vor der Sensorelektrode erfasst werden soll, und einer mit der Sensorelektrode gekoppelten Steuer- und Auswerteschaltung, die eine Änderung der Kapazität der Sensorelektrode gegenüber einem Referenzpotential erfasst, indem sie die Sensorelektrode mit einer vorgegebenen Frequenz periodisch wiederholt mit einem vorgegebenen ersten Potential koppelt und wenigstens einen Parameter eines vom periodischen Laden und Entladen der Sensorelektrode abhängigen Strom- oder Spannungsverlaufs zur Erfassung der Kapazitätsänderung auswertet.

Eine kapazitive Sensoranordnung der eingangs genannten Art, bei der das Referenzpotential ein Masse-Potential und das erste Potential ein Betriebsspannungspotential ist und bei der der Parameter eines vom periodischen Laden und Entladen der Sensorelektrode abhängigen Strom- oder Spannungsverlaufs eine über einem Kondensator messbare Spannung ist, die von der auf dem Kondensator angesammelten Ladung abhängt, wobei diese Ladung dadurch angesammelt wird, dass periodisch wiederholt die Sensorelektrode durch Koppeln mit einem Spannungsversorgungspotential aufgeladen und anschließend durch Koppeln mit dem Kondensator über diesen entladen wird, ist beispielsweise aus dem US-Patent 5,730,165 bzw. der entsprechenden Patentschrift DE 196 81 725 B4 bekannt. Andere derartige kapazitive Sensoren sind aus der Patentschrift EP 1 339 025 B1 oder der US 2008/0042660 A1 bekannt.

Eine kapazitive Sensoranordnung mit einer Sensorelektrode, mit einer beabstandet hinter der Sensorelektrode angeordneten Masse-Hintergrundelektrode und mit einer Schirmelektrode, die zwischen der Sensorelektrode und der Masse-Hintergrundelektrode angeordnet ist und die über eine Steuer- und Auswerteschaltung derart mit der Sensorelektrode gekoppelt ist, dass sie keinen Einfluss auf die gegenüber Masse gemessene Kapazität der Sensorelektrode hat und dass ihr Potential dem Potential der Sensorelektrode nachgeführt wird, ist beispielsweise aus den Veröffentlichungen EP 0 518 836 A1, US 6,825,752 B2, DE 101 31 243 C1 und DE 10 2006 044 778 A1 bekannt. Das aus diesen Druckschriften bekannte Vorsehen einer Schirmelektrode zwischen der Sensorelektrode und der auf Masse-Potential liegenden Hintergrundelektrode hat den Vorteil, dass die Empfindlichkeit des so gebildeten kapazitiven Sensors gegenüber Veränderungen im Raum vor der Sensorelektrode, beispielsweise durch Einbringen von Objekten, erhöht wird. Dies liegt vor allem daran, dass sich das von der Sensorelektrode ausbreitende Feld stärker in den Raum vor der Sensorelektrode erstreckt, weil nicht mehr - wie bei fehlender Schirmelektrode - ein großer Teil des Feldes zu der auf Masse-Potential liegenden Hintergrundelektrode kurzgeschlossen wird. Aufgrund des Umstands, dass die Schirmelektrode derart mit der Sensorelektrode gekoppelt ist, dass sie deren Potential nachgeführt wird, entsteht das starke elektrische Feld zwischen der Schirmelektrode und der Hintergrundelektrode; vor allem aber bildet sich praktisch kein Feld aus zwischen der Sensorelektrode und der potentialmäßig nachgeführten Schirmelektrode. Aus der Patentschrift US 6,445,294 B1 ist eine Sensoranordnung bekannt, umfassend eine Sensorelektrode, eine Hintergrundelektrode und eine zwischen der Sensorelektrode und der Hintergrundelektrode angeordnete Schirmelektrode, wobei die Hintergrundelektrode komplementär zu der Sensorelektrode umgeschaltet wird. Aus der GB 2 404 443 A ist ferner eine Anordnung bekannt, bei der eine erste Schirmelektrode zwischen der Sensorelektrode und Masse und zusätzlich eine zweite Schirmelektrode zwischen der ersten Schirmelektrode und Masse vorgesehen ist. Beide Schirmelektrodenpotentiale werden dem Sensorpotential nachgeführt. Die zweite Schirmelektrode dient dazu, die effektive Kapazität der ersten Schirmelektrode gegenüber Masse zu verringern und somit ein genaueres Nachführen des Potentials der ersten Schirmelektrode gegenüber der Sensorelektrode zu ermöglichen.

Der Erfindung liegt die Aufgabe zugrunde, den räumlichen Bereich, in dem die kapazitive Sensoranordnung das Eindringen eines vorgegebenen Objekts erfassen kann, das heißt den Detektionsbereich, besser eingrenzen zu können, beispielsweise gezielter auszurichten.

Diese Aufgabe wird erfindungsgemäß durch eine kapazitive Sensoranordnung mit den Merkmalen des Anspruchs 1 gelöst. Die erfindungsgemäße kapazitive Sensoranordnung umfasst eine Sensorelektrode, mit deren Hilfe das Eindringen eines Objekts in einen Raum vor der Sensorelektrode erfasst werden soll, wenigstens eine Hintergrundelektrode, die beabstandet hinter der Sensorelektrode angeordnet ist, und eine Schirmelektrode. Eine mit der Sensorelektrode gekoppelte Steuer- und Auswerteschaltung erfasst eine Änderung der Kapazität der Sensorelektrode gegenüber einem Referenzpotential, vorzugsweise einem Masse-Potential, indem sie die Sensorelektrode mit einer vorgegebenen Frequenz periodisch wiederholt mit einem vorgegebenen ersten Potential, beispielsweise einem Betriebsspannungspotential, koppelt und wenigstens einen Parameter eines vom periodischen Laden und Entladen der Sensorelektrode abhängigen Strom- und Spannungsverlaufs zur Erfassung der Kapazitätsänderung auswertet. Der Spannungsverlauf kann beispielsweise der Spannungsverlauf am Anschluss der Sensorelektrode sein. Der Parameter kann beispielsweise eine Spannung, die über einem Ladung ansammelnden Kondensator gemessen wird, oder eine bestimmte Anzahl von Perioden des Ladens und Entladens bis zum Überschreiten einer Schaltschwelle durch eine an der Sensorelektrode gemessene Spannung sein. Die Schirmelektrode ist über die Steuer- und Auswerteschaltung derart mit der Sensorelektrode gekoppelt, dass sie keinen Einfluss auf die gegenüber dem Referenzpotential gemessene Kapazität der Sensorelektrode hat und dass ihr Potential dem Potential der Sensorelektrode im Wesentlichen nachgeführt wird. Mit dem Begriff des "Nachführens" soll hier zum Ausdruck gebracht werden, dass das Potential der Schirmelektrode nicht gleich dem Potential der Sensorelektrode zu sein braucht und dass es einen zeitlichen Versatz zwischen dem Verlauf des Potentials der Sensorelektrode und dem Potential der Schirmelektrode geben kann. Mit den Worten "im Wesentlichen" soll darüber hinaus zum Ausdruck gebracht werden, dass die Schirmelektrode nicht über die vollen Perioden des Ladens und Entladens der Sensorelektrode dem Potential der Sensorelektrode folgen muss; es genügt, wenn sie diesem Potential zumindest in Teilabschnitten der Perioden folgt, beispielsweise während des Aufladens der Sensorelektrode deren Potential folgt und während des Entladens der Sensorelektrode auf das Masse-Referenzpotential abfällt, während das Potential der Sensorelektrode noch auf einem von Masse verschiedenen Potential verbleibt. Die Hintergrundelektrode oder wenigstens eine der Hintergrundelektroden ist mit der Steuer- und Auswerteschaltung gekoppelt und wird derart angesteuert, dass ihr Potential mit der vorgegebenen Frequenz periodisch zwischen dem Referenzpotential und einem zweiten Potential, das gegenüber dem Referenzpotential dieselbe Polarität wie das erste Potential hat, umgeschaltet wird, wobei die Hintergrundelektrode zumindest während eines Teil derjenigen Zeiten, in denen die Sensorelektrode mit dem ersten Potential gekoppelt wird, auf das Referenzpotential gelegt wird, und zumindest während eines Teils derjenigen Zeiten, in denen sich die Sensorelektrode nicht mit dem ersten Potential gekoppelt wird, auf das zweite Potential gelegt wird. Das zweite Potential kann wiederum die Betriebsspannung sein oder auch eine davon abweichende (kleinere oder größere) Spannung. Zwar ist der Potentialverlauf der Hintergrundelektrode komplementär zu dem der Sensorelektrode und der Schirmelektrode; jedoch kann es bei bestimmten Ausführungsbeispielen sowohl einen zeitlichen Versatz zwischen dem Umschalten der Sensorelektrode und dem Umschalten der Hintergrundelektrode geben als auch ein abweichendes Tastverhältnis beim Umschalten geben.

Die Erfindung basiert auf der Grundidee, anstelle einer stets auf einem konstanten Masse- und BetriebsspannungsPotential liegenden Hintergrundelektrode eine Hintergrundelektrode zu verwenden, die beim Umschalten der Sensorelektrode zwischen dem ladenden und dem entladenden Zustand die Hintergrundelektrode komplementär zwischen dem Massepotential und dem Betriebsspannungspotential umschaltet, wobei auch Ausführungsformen abgedeckt sein sollen, bei denen das Umschalten zeitlich versetzt, mit abweichendem Tastverhältnis oder bei abweichenden Potentialen geschieht.

Bei der bevorzugten Ausführungsordnung der kapazitiven Sensoranordnung ist das Referenzpotential Masse und entsprechen das erste Potential und das zweite Potential dem Potential einer Versorgungsspannung der Steuer- und Auswerteschaltung gegenüber Masse. Bei der bevorzugten Ausführungsform wird die Hintergrundelektrode derart angesteuert, dass das Potential der Hintergrundelektrode während derjenigen Zeiten, in denen sich die Sensorelektrode auf dem ersten Potential, das heißt vorzugsweise auf Versorgungsspannung, befindet, auf das Referenzpotential, vorzugsweise Masse, gelegt wird. Vorzugsweise wird die Hintergrundelektrode ferner derart angesteuert, dass das Potential der Hintergrundelektrode während derjenigen Zeiten, in denen sich die Sensorelektrode nicht auf den ersten Potential, das heißt vorzugsweise nicht auf Betriebsspannung befindet, auf das zweite Potential gelegt wird. Vorzugsweise wird die Hintergrundelektrode derart angesteuert, dass das Potential der Hintergrundelektrode mit dem gleichen Tastverhältnis auf das Referenzpotential geschaltet wird, mit dem die Sensorelektrode auf das erste Potential geschaltet wird. Bei der bevorzugten Ausführungsform beträgt das Tastverhältnis 50 % und werden die beiden Elektroden synchron umgeschaltet. Aus diesem Grund wird die Hintergrundelektrode bei der bevorzugten Ausführungsform "Komplementärelektrode" genannt.

Es sind Ausführungsformen denkbar, bei denen sich hinter der Schirmelektrode und der Sensorelektrode mehrere nebeneinander angeordnete Hintergrundelektroden befinden, von denen zumindest eine mit der Steuer- und Auswerteschaltung gekoppelt ist und derart angesteuert wird, dass ihr Potential periodisch mit der vorgegebenen Frequenz zwischen dem Referenzpotential und dem zweiten Potential umgeschaltet wird. Die anderen Hintergrundelektroden können beispielsweise auf dem Referenzpotential liegen. Es könnte auch hinter der Hintergrundelektrode eine auf konstantem Potential, beispielsweise auf Masse, liegende weitere Elektrode vorgesehen sein.

Die Frequenz mit der die Sensorelektrode periodisch wiederholt mit einem vorgegebenen ersten Potential, beispielsweise mit einer Betriebsspannung, gekoppelt wird, liegt beispielsweise im Bereich zwischen 50 kHz und 5 MHz, vorzugsweise zwischen 125 kHz und 1 MHz.

Eine bevorzuge Weiterbildung der erfindungsgemäßen kapazitiven Sensoranordnung ist **dadurch gekennzeichnet, dass** die Sensorelektrode, ein mit der Sensorelektrode verbundener Referenzkondensator, die Schirmelektrode und die Hintergrundelektrode jeweils mit wenigstens einem Ausgabe-Port eines Mikrocontrollers verbunden sind, wobei der Mikrocontroller in der Auswerte- und Steuerschaltung ist und über die Ports die Elektroden entweder mit einer Betriebsspannung oder mit Masse koppeln oder hochohmig entkoppeln kann, so dass der Mikrocontroller programmgesteuert den Port der Sensorelektrode abwechselnd auf die Betriebsspannung legt und hochohmig entkoppelt, den Port des Referenzkondensators im Wesentlichen synchron mit dem Port der Sensorelektrode abwechseln hochohmig entkoppelt und auf Masse legt, die Schirmelektrode dem Potential der Sensorelektrode nachführt, indem er den Port der Schirmelektrode synchron mit dem Port der Sensorelektrode abwechselnd auf die Betriebsspannung und auf Masse legt, und den Port der Hintergrundelektrode zwischen Masse und Betriebsspannung umschaltet, wobei der Port der Hintergrundelektrode zumindest während eines Teils derjenigen Zeiten, in denen sich der Port der Sensorelektrode auf Betriebsspannung befindet, auf Masse gelegt wird, und zumindest während eines Teils derjenigen Zeiten, in denen sich der Port der Sensorelektrode nicht auf Betriebsspannung befindet, auf Betriebsspannung gelegt wird. Bei einer Weiterbildung dieser bevorzugten Ausführungsform sind sowohl die Schirmelektrode als auch die Komplementärelektrode mit jeweils zwei Ports des Mikrocontrollers gekoppelt, wobei der eine Port dazu dient, die zugehörige Elektrode auf Betriebsspannung zu legen, während der andere Port dazu dient, die zugehörige Elektrode auf Masse zu legen. Dies führt zu einer höheren Umschaltgeschwindigkeit.

Bei einer bevorzugten Ausführungsform der zuletzt genannten Weiterbildung weist der Port der Sensorelektrode zusätzlich einen Eingabe-Port mit einem A/D-Wandler auf, der dann aktiviert wird, wenn der Ausgabeport hochohmig entkoppelt ist. Dadurch kann der Eingabe-Port die über dem Referenzkondensator akkumulierte Ladung in Form der anliegenden Spannung messen, wobei der A/D-Wandler einen dieser Spannung entsprechenden Digitalwert ausgibt. Der gegebene Digitalwert wird dann beispielsweise mit einem Referenz-Digitalwert verglichen, der einer vorgegebenen Spannungsschwelle entspricht.

Eine Ausführungsform der oben beschriebenen Sensoranordnung könnte beispielsweise im Heck-Stoßfänger eines Kraftfahrzeugs angeordnet sein und gezielt die Annäherung eines Bedienerkörperteils (Fußes) erfassen und in Abhängigkeit davon ein Heckklappenschloss freigeben.

Vorteilhafte und/oder bevorzugte Weiterbildungen der Erfindung sind in den Unteransprüchen gekennzeichnet.

Im Folgenden wird die Erfindung anhand von in den Zeichnungen dargestellten bevorzugten Ausführungsbeispielen näher erläutert. In den Zeichnungen zeigen:
Figur 1 eine schematische Darstellung der Anordnung der drei Elektroden der bevorzugten Ausführungsform der kapazitiven Sensoranordnung und deren Kopplung mit einer Steuer- und Auswerteschaltung;
Figur 2 eine schematische Darstellung der Potentialverläufe über der Sensorelektrode, der Schirmelektrode und der Hintergrundelektrode bei dem bevorzugten Ausführungsbeispiel;
Figur 3 eine schematische Darstellung der bevorzugten Ausführungsform der erfindungsgemäßen Sensoranordnung, bei der die drei Elektroden mit Ausgabe-Ports eines Mikrocontrollers gekoppelt sind; und
Figur 4 Potentialverläufe für die drei Elektroden mit alternativen Ansteuerungen der Hintergrundelektrode.

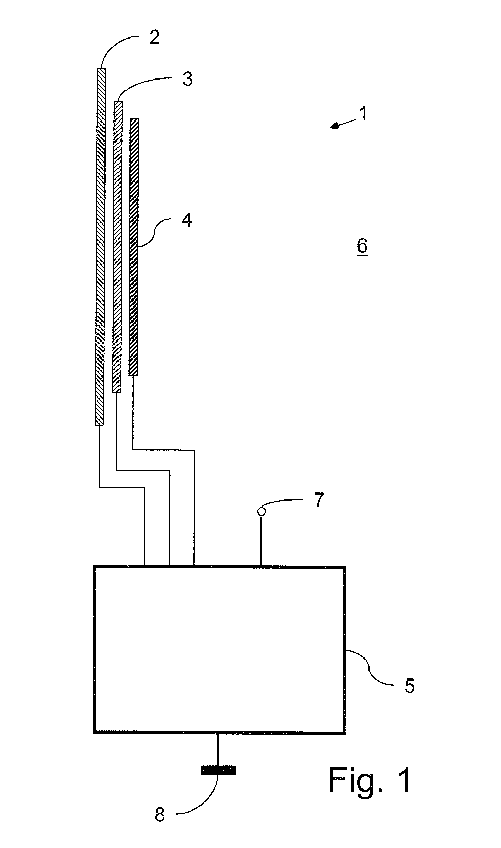

Figur 1 zeigt eine schematische Darstellung der erfindungsgemäßen kapazitiven Sensoranordnung, welche eine Sensorelektrodenanordnung 1 und eine Steuer- und Auswerteschaltung 5 umfasst. Die einzelnen Elektroden der Sensorelektrodenanordnung 1 sind über Signalleitungen mit der Steuer- und Auswerteschaltung 5 gekoppelt, wobei die Steuer- und Auswerteschaltung auch mehrere baulich getrennte Komponenten umfassen kann, die an unterschiedlichen Orten angeordnet sind. Vorzugsweise sind diejenigen Bestandteile der Steuer- und Auswerteschaltung 5, welche die Elektroden der Sensorelektrodenanordnung 1 mit vorgegebenen Spannungen beaufschlagen bzw. die Spannungspotentiale einzelner Sensorelektroden erfassen, in der Nähe der Sensorelektrodenanordnung 1 angeordnet, um die Zuleitungslängen kurz und die parasitären Kapazitäten möglichst gering zu halten.

Die Sensorelektrodenanordnung 1 ist vorzugsweise auf einer Objektoberfläche angeordnet, vor der sich ein zu überwachender Raum 6 befindet, wobei die kapazitive Sensoranordnung das Eindringen eines Objekts in diesen Raum 6 erfassen soll. Welche Dimensionen dieser Raum 6 aufweist, hängt einerseits von der Größe und Form der Sensorelektrodenanordnung 1 und andererseits von der Empfindlichkeit der mit der Sensorelektrodenanordnung 1 gekoppelten Steuer- und Auswerteschaltung 5 ab. Die Sensorelektrodenanordnung 1 kann beispielsweise auf oder unmittelbar hinter Oberflächen eines Kraftfahrzeugbauteils, beispielsweise eines Türgriffs, angeordnet sein, um das Eindringen eines Bedienerkörperteils in den Raum 6 vor der Sensorelektrodenanordnung 1 zu erfassen. Beispielsweise werden bestimmte Schaltvorgänge oder andere Abläufe in dem Kraftfahrzeug ausgelöst, sofern das Eindringen eines Bedienerkörperteils in den Raum 6 von der Sensorelektrodenanordnung 1 erfasst wird.

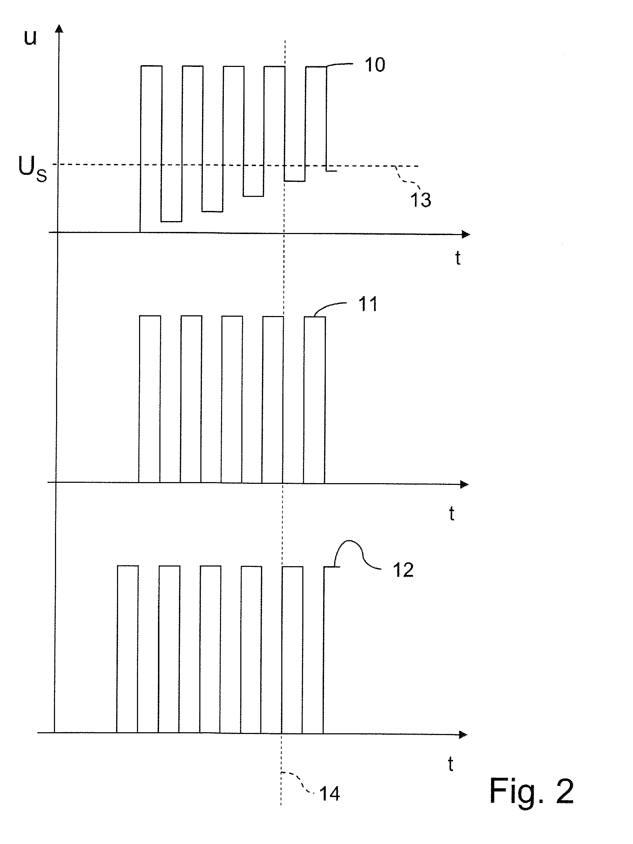

Die in Figur 1 dargestellte Sensorelektrodenanordnung 1 umfasst zunächst eine Sensorelektrode 4, mit deren Hilfe das Eindringen eines Objekts in den Raum 6 erfasst werden soll. Die mit der Sensorelektrode 4 über eine Signalleitung gekoppelte Steuer- und Auswerteschaltung 5 erfasst eine Änderung der Kapazität der Sensorelektrode gegenüber einem Referenzpotential, vorzugsweise gegenüber Masse, indem sie die Sensorelektrode 4 mit einer vorgegebenen Frequenz periodisch wiederholt mit einem vorgegebenen ersten Potential, beispielsweise der Betriebsspannung, koppelt und wenigstens einen Parameter eines vom periodischen Laden und Entladen der Sensorelektrode 4 abhängigen Strom- oder Spannungsverlaufs zur Erfassung der Kapazitätsänderung auswertet. Wie dies bei einem bevorzugten Ausführungsbeispiel geschieht, wird weiter unten anhand der Figur 2 erläutert.

Die Sensorelektrodenanordnung 1 umfasst ferner eine Schirmelektrode 3, welche beabstandet hinter der Sensorelektrode 4 angeordnet ist, sowie eine Hintergrundelektrode 2, welche wiederum beabstandet hinter der Schirmelektrode 3 angeordnet ist. Die Schirmelektrode 3 ist über die Steuer- und Auswerteschaltung 5 derart mit der Sensorelektrode 4 gekoppelt, dass sie keinen Einfluss auf die gegenüber dem Referenzpotential (Masse beispielsweise) gemessene Kapazität der Sensorelektrode 4 hat und dass ihr Potential dem Potential der Sensorelektrode 4 nachgeführt wird. Wie dies bei dem bevorzugten Ausführungsbeispiel ausgeführt wird, wird ebenfalls unten anhand Figur 2 näher beschrieben.

Die Hintergrundelektrode 2 wird derart angesteuert, dass ihr Potential mit derselben vorgegebenen Frequenz periodisch zwischen dem Referenzpotential (beispielsweise Masse) und einem zweiten Potential umgeschaltet wird. Das zweite Potential hat gegenüber dem Referenzpotential dieselbe Polarität wie das erste Potential und kann beispielsweise auch gleich dem ersten Potential sein. Zumindest während eines Teils derjenigen Zeiten, in denen die Sensorelektrode 4 mit dem ersten Potential gekoppelt wird, wird die Hintergrundelektrode auf das Referenzpotential, beispielsweise Masse, gelegt. Zumindest während eines Teils derjenigen Zeiten, in denen die Sensorelektrode 4 nicht mit dem ersten Potential gekoppelt wird, wird die Hintergrundelektrode 2 auf das zweite Potential gelegt. Auch dies wird für ein bevorzugtes Ausführungsbeispiel anhand der Figur 2 näher beschrieben.

Die Sensorelektrodenanordnung 1 mit Hintergrundelektrode 2, Schirmelektrode 3 und Sensorelektrode 4 kann von unterschiedlicher Gestalt sein. Es brauchen nicht zueinander parallele ebene Plattenelektroden verwendet zu werden; die Elektroden können auch beispielsweise gekrümmt sein. Die Größe der Elektroden hängt vom jeweiligen Einsatzgebiet ab. Soll beispielsweise ein relativ kleiner Raum 6 in unmittelbarer Nähe einer Sensorfläche geringer Abmessungen überwacht werden, wie dies beispielsweise bei einem Berührungsschalter an einem Türgriff der Fall sein könnte, so sind die Abmessungen der Sensorelektrode 4 sowie der dahinter angeordneten Schirmelektrode 3 und Hintergrundelektrode 2 ebenfalls relativ gering. Die Elektroden können aus einem beliebigen leitfähigen Material bestehen; beispielsweise kann es sich um Metallisierungsebenen einer mehrlagigen Leiterplatte handeln. Die Sensorelektroden 2, 3 und 4 werden durch Isolatorschichten voneinander getrennt, wobei die Isolatorschichten beispielsweise aus Kunststoff bestehen können.

Die Spannungsversorgung der Steuer- und Auswerteschaltung 5 ist in Figur 1 durch den Versorgungsspannungsanschluss 7 und den Masseanschluss 8 symbolisiert. Selbstverständlich sind auch Ausführungsformen denkbar, bei denen der Steuer- und Auswerteschaltung 5 mehrere unterschiedliche Versorgungsspannungen zugeführt werden.

Figur 2 zeigt schematisch, welche Spannungsverläufe (oder Potentialverläufe in Bezug auf ein Referenzpotential, wie beispielsweise Masse) sich aufgrund der Ansteuerung durch die Steuer- und Auswerteschaltung 5 an den Elektroden ergeben. Der oben dargestellte Verlauf 10 zeigt den Potentialverlauf an der Sensorelektrode 4. Bei diesem Ausführungsbeispiel wird die Sensorelektrode 4 periodisch wiederholt für eine vorgegebene Zeit mit einer Betriebsspannung verbunden, so dass das Potential des Potentialverlaufs 10 in diesen Zeiten auf die hohe Betriebsspannung ansteigt und dort für die Zeit des Anliegens der Betriebsspannung verweilt. Dabei wird die Sensorelektrode, welche eine Kapazität gegenüber dem Referenzpotential Masse aufweist, aufgeladen. Während jeweils der zweiten Hälfte jeder Periode wird die Sensorelektrode 4 mit einer Elektrode eines Referenzkondensators gekoppelt, während die andere Elektrode des Referenzkondensators mit Masse gekoppelt wird. Dabei überträgt sich ein Teil der auf der Sensorelektrode 4 angesammelten Ladung auf den Referenzkondensator 4. Die angesammelte Ladung und somit auch die übertragene Ladung hängen beispielsweise davon ab, ob sich ein Objekt in Raum 6 vor der Sensorelektrode 4 befindet. In diesen Zeitperioden sinkt das Potential an der Sensorelektrode 4 bzw. die Spannung zwischen dem Verbindungsknoten zwischen der Sensorelektrode 4 und dem Referenzkondensator und Masse auf einen Wert ab, der proportional der auf den Referenzkondensator übertragenen Ladung ist. Der Vorgang des Aufladens der Sensorelektrode 4 durch Verbinden mit der Betriebsspannung und des Entladens der Sensorelektrode 4 über den Referenzkondensator wird mehrfach wiederholt, wobei jeweils erneut Ladung von der Sensorelektrode 4 auf den Referenzkondensator übertragen wird. Dies wiederum hat zur Folge, dass der Potentialverlauf 10 während der Zeiten, in denen sich das Potential auf dem niedrigen Pegel befindet, langsam ansteigt. Dabei wird von einer mit dem Verbindungsknoten zwischen der Sensorelektrode 4 und dem Referenzkondensator verbundenen Schaltung erfasst, ob dieses Potential eine Schwellenspannung U_{S} überschreitet. Ferner werden die Impulse gezählt, die erforderlich sind, um diesen Anstieg über die Schwellenspannung U_{S} zu bewirken. Die Anzahl dieser Impulse ist ein Maß für die Kapazität der Sensorelektrode 4 gegenüber dem Referenzpotential (Masse). Sofern die Sensorelektrode eine relativ hohe Kapazität gegenüber Masse aufweist, weil beispielsweise ein mit Masse gekoppeltes Objekt in den Raum 6 eingedrungen ist und sich in der Nähe der Sensorelektrode 4 befindet, so sind nur relativ wenige Impulse erforderlich, um das Überschreiten des Schwellenwerts U_{S} zu bewirken. Hat die Sensorelektrode 4 eine relativ geringe Kapazität gegenüber Masse, weil beispielsweise der Raum 6 leer ist, so sind relativ viele Impulse erforderlich, um diese Überschreiten des Schwellenwerts U_{S} zu bewirken. Nachdem das Überschreiten des Schwellenwerts festgestellt worden ist, beginnt der Messzyklus von neuem, indem der Referenzkondensator zunächst entladen wird. Anschließend werden wiederum die Zyklen gezählt, die erforderlich sind, damit die Spannung über dem Referenzkondensator den Schwellenwert U_{S} überschreitet.

Selbstverständlich sind bei alternativen Ausführungsformen auch andere Vorgehensweise denkbar, um eine Kapazitätsänderung der Sensorelektrode 4 durch Auswerten eines Parameters eines vom periodischen Laden und Entladen der Sensorelektrode 4 abhängigen Strom- oder Spannungsverlaufs zu erfassen. So könnte beispielsweise der Referenzkondensator zunächst auf einen fest vorgegebenen negativen Wert aufgeladen und dann durch Ladungsverschiebung von der Sensorelektrode 4 mit jedem Zyklus ein Stück entladen werden. Auch kann das Aufladen der Sensorelektrode 4 durch Koppeln mit einer Stromquelle für eine vorgegebene Zeitdauer realisiert werden.

In dem mittleren Teil der Figur 2 ist der Potentialverlauf 11 an der Schirmelektrode 3 skizziert. Es ist zu erkennen, dass das Potential der Schirmelektrode 3 dem Potential der Sensorelektrode 4 nachgeführt wird, indem dann, wenn die Sensorelektrode mit dem ersten Potential, beispielsweise mit Betriebsspannung, gekoppelt wird, auch die Schirmelektrode mit diesem ersten Potential gekoppelt wird, so dass das Potential der Schirmelektrode 3 synchron mit dem Potential der Sensorelektrode 4 auf den hohen Pegel gebracht wird. In denjenigen Intervallen, in denen dann die Sensorelektrode 4 über den Referenzkondensator mit Masse gekoppelt wird, wird die Schirmelektrode 3 beispielsweise direkt mit Masse gekoppelt, so dass der Potentialverlauf 11 auf das Referenzpotential Masse abfällt. Genau betrachtet, wird das Potential der Schirmelektrode 3 dem Potential der Sensorelektrode 4 nur näherungsweise nachgeführt; ein exaktes Nachführen findet hier nur während derjenigen Intervalle statt, in denen beide Elektroden auf das hohe Potential gelegt werden. Während derjenigen Intervalle, in denen die Schirmelektrode 3 auf das Massepotential gelegt wird, folgt sie nicht dem Potential der Sensorelektrode 4, welches langsam in Abhängigkeit von der Aufladung des Referenzkondensators ansteigt, bis es den Schwellenwert U_{S} überschreitet. Dieser langsamer Anstieg des Potentials der Sensorelektrode 4 während der Intervallabschnitte mit niedrigem Potential ist jedoch wesentlich geringer als die Höhe der Impulse, das heißt als das erste Potential, beispielsweise die Betriebsspannung. Aus diesem Grund kann während des gesamten Potentialverlaufs 11 der Schirmelektrode 3 von einem Nachführen gesprochen werden.

Im unteren Abschnitt der Figur 2 ist der Potentialverlauf 12 für die Hintergrundelektrode 2 dargestellt. Auch diese wird periodisch abwechselnd auf ein hohes, erstes Potential, beispielsweise die Betriebsspannung, und dann wieder auf ein niedriges Potential, beispielsweise Masse, gelegt. Allerdings ist hier der Potentialverlauf komplementär zu den Potentialverläufen der Sensorelektrode 4 und der Schirmelektrode 3. Immer dann, wenn die Sensorelektrode 4 und die Schirmelektrode 3 auf das hohe Potential gebracht werden, wird die Hintergrundelektrode auf das niedrige Potential, insbesondere auf Masse, gelegt. Dann, wenn sich die Sensorelektrode 4 auf einen niedrigen Potential und die Schirmelektrode 3 auf dem Masse-Potential befinden, wird die Hintergrundelektrode 2 auf das hohe Potential, beispielsweise die Betriebsspannung, gelegt. Um diese Gegenphasigkeit der Potentialverläufe besser erkennen zu können, wurde in Figur 2 die senkrechte Linie 14 eingefügt.

Es hat sich gezeigt, dass durch eine derartige komplementäre Ansteuerung der Hintergrundelektrode 2 im Unterschied zu einer Sensoranordnung, bei der die Hintergrundelektrode 2 lediglich konstant auf Masse gelegt wird, eine stärkere Richtwirkung bezüglicher Empfindlichkeitsverteilung ergibt. Der Detektionsbereich, in welchem das Eindringen eines vorgegebenen Objekts bei einer vorgegebenen Sensoranordnung erfasst wird, erstreckt sich im Unterschied zur herkömmlichen Ansteuerung der Elektrodenanordnung weiter in den Raum 6 vor der Sensorelektrode 4 und weniger in einen Raumbereich hinter der Hintergrundelektrode 2. Durch die erfindungsgemäße Ansteuerung der Hintergrundelektrode 2 ist eine gute Trennung und Ausrichtung des Feldes bzw. des Detektionsbereiches möglich.

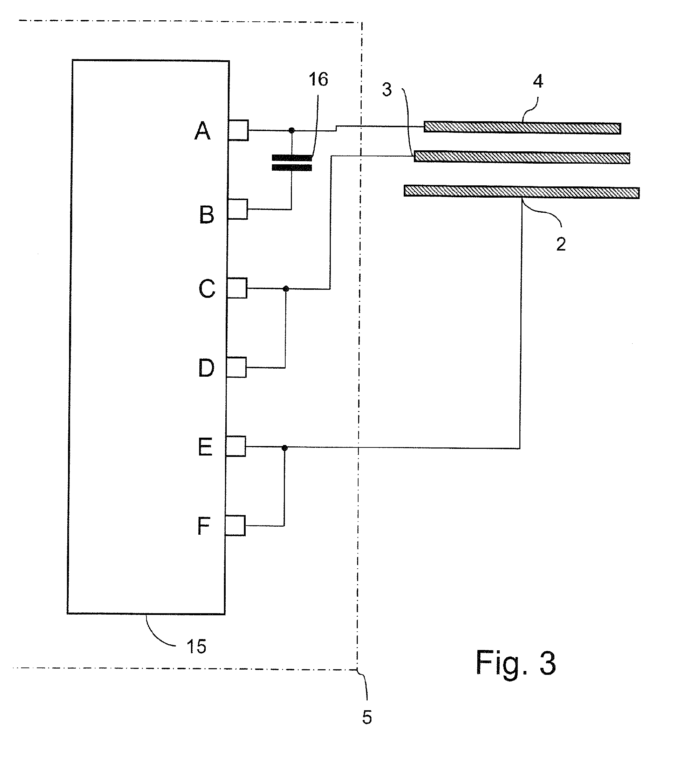

Figur 3 zeigt eine schematische Darstellung einer bevorzugten Ausführungsform der Steuer- und Auswerteschaltung 5 für die aus Sensorelektrode 4, Schirmelektrode 3 und Hintergrundelektrode 2 bestehende Sensorelektrodenanordnung 1. Die Steuer- und Auswerteschaltung 5 umfasst hierbei einen Mikrocontroller 15, der mindestens sechs Ausgabe-Ports aufweist, die in Figur 3 mit den Buchstaben A - F gekennzeichnet sind. Die Sensorelektrode 4 ist mit dem Ausgabe-Port A gekoppelt. Ferner ist der Referenzkondensator 16 zwischen dem Ausgabe-Port A und dem Ausgabe-Port B eingekoppelt. Die Schirmelektrode 3 ist mit den Ausgabe-Ports C und D gekoppelt, welche miteinander verbunden sind. Die Hintergrundelektrode 2 ist mit den miteinander gekoppelten Ausgabe-Ports E und F verbunden. Jeder der sechs Ausgabe-Ports A - F ist derart gestaltet, dass er seinen Ausgangsanschluss über einen ersten elektronischen Schalter mit einer Betriebsspannung oder über einen zweiten elektronischen Schalter mit Masse koppeln kann. Sind beide elektronische Schalter ausgeschaltet, so befindet sich der zugehörige Ausgangsanschluss hochohmig auf schwebendem Potential, sofern er nicht über eine äußere Beschaltung mit einem anderen Potential gekoppelt ist. Jeder der Ausgabe-Ports kann durch Abarbeitung einer in dem Mikrocontroller 15 gespeicherten Steuerungssoftware in einen der drei Zustände Betriebsspannung, Masse oder hochohmig gebracht werden. Um eine der Elektroden (beispielsweise 2 oder 3) abwechselnd auf Betriebsspannung und Masse zu legen, würde es theoretisch genügen, diese Sensorelektrode mit einem der Ports zu koppeln, wobei dann dieser Ausgabe-Port abwechselnd auf Masse und Betriebsspannung geschaltet wird. Dies würde aber zu relativ langen Umschaltzeiten führen, wenn ein und derselbe Ausgabe-Port abwechselnd zwischen Betriebsspannung und Masse umgeschaltet werden soll. Aus diesem Grund ist es bei dem bevorzugten Ausführungsbeispiel vorgesehen, dass jede der beiden Elektroden 2 und 3 jeweils mit zwei Ausgabe-Ports gekoppelt ist. Einer der beiden Ausgabe-Ports sorgt dafür, dass die zugehörige Elektrode (2 oder 3) auf Betriebsspannung gelegt werden kann, während der andere Ausgabe-Port für die Kopplung mit Masse verantwortlich ist. Während beispielsweise der Ausgabe-Port C die Schirmelektrode 3 mit der Betriebsspannung koppelt, befindet sich der andere Ausgabe-Port D im hochohmigen Zustand. Wenn dann anschließend der Ausgabe-Port D die Schirmelektrode 3 mit Masse koppelt, befindet sich der Ausgabe-Port C im hochohmigen Zustand. Gleiches gilt für die Ausgabe-Ports E und F, die mit der Hintergrundelektrode 2 verbunden sind.

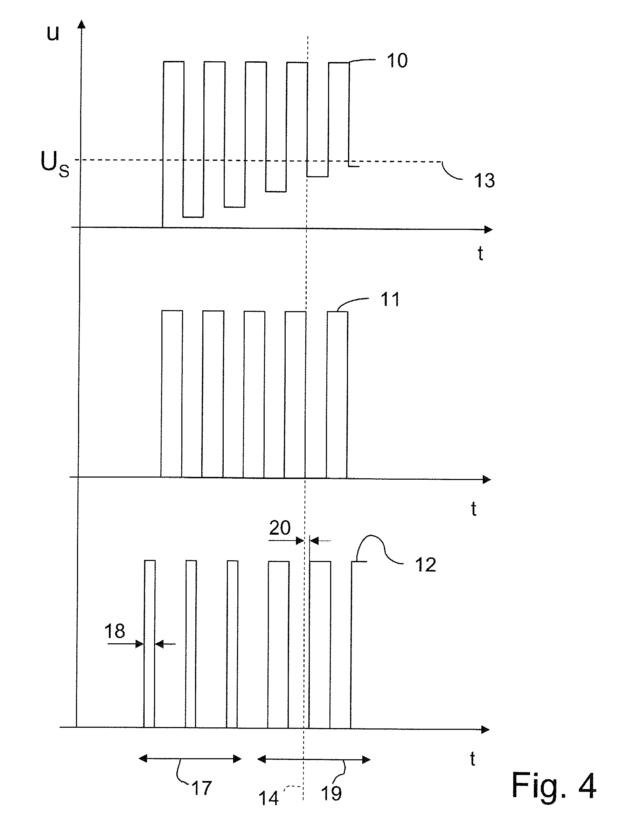

Der in Figur 2 dargestellte Potentialverlauf wird mit Hilfe der in Figur 3 schematisch dargestellten Mikrocontroller-Steuerung erzeugt, indem der Mikrocontroller durch Abarbeitung eines Steuerprogramms nacheinander folgende Zustände der Ausgabe-Ports A bis F einstellt. Wenn die Sensorelektrode 4 aufgeladen werden soll, so koppelt der Port A die Zuleitung zur Sensorelektrode 4 mit der Betriebsspannung. Gleichzeitig koppelt der Port C die Schirmelektrode 3 ebenfalls mit Betriebsspannung. Der Port F koppelt die Hintergrundelektrode 2 mit Masse. Gleichzeitig sind die anderen Ports B, D und E im hochohmigen Zustand. Wenn dann die auf der Sensorelektrode angesammelte Ladung zum Teil auf den Referenzkondensator 16 übertragen werden soll, wird zunächst der Ausgabe-Port A in den hochohmigen Zustand versetzt und dann sogleich der Ausgabe-Port B mit Masse gekoppelt. Gleichzeitig wird der Ausgabe-Port C in den hochohmigen Zustand versetzt und der Ausgabe-Port D mit Masse gekoppelt, so dass die Schirmelektrode 3 der Sensorelektrode 4 nachgeführt wird. Ebenfalls etwa gleichzeitig wird der Ausgabe-Port F in den hochohmigen Zustand versetzt und der Ausgabe-Port E mit Betriebsspannung gekoppelt. Bei diesem Ausführungsbeispiel schalten die Ports A, C und F bzw. die Ports B, D und E vorzugsweise etwa gleichzeitig. Bei einem alternativen Ausführungsbeispiel können selbstverständlich auch die Ports E und F oder C und D hinsichtlich ihrer Ansteuerung vertauscht werden. Bei anderen alternativen Ausführungsformen ist es denkbar, dass die einzelnen Elektroden zwar mit der gleichen Grundfrequenz aber zu verschiedenen Zeitpunkten geschaltet werden. Beispielsweise funktioniert die Sensoranordnung auch dann noch, wenn das Schalten der Schirmelektrode 3 gegenüber dem Schalten der Sensorelektrode geringfügig versetzt erfolgt. Gleiches gilt für das Schalten der Hintergrundelektrode 2. Darüber hinaus kann das Umschalten der einzelnen Elektroden mit unterschiedlichen Tastverhältnissen der Impulse erfolgen. Dies sei anhand der in Figur 4 gezeigten abweichenden Signalverläufe für die Hintergrundelektrode veranschaulicht.

Figur 4 zeigt wiederum eine schematische Darstellung der Potentialverläufe, wobei der Potentialverlauf 10 der Sensorelektrode 4 und der Potentialverlauf 11 der Schirmelektrode 3 denen der Figur 2 entsprechen. Im unteren Abschnitt der Figur 4 sind mögliche Potentialverläufe 12 der Hintergrundelektrode 2 bei alternativen Ausführungsformen dargestellt. In dem Zeitintervall 17 ist ein Potentialverlauf dargestellt, bei dem diejenigen Intervallabschnitte, in denen die Hintergrundelektrode auf das hohe Potential der Betriebsspannung gebracht wird, kürzer sind als die Intervallabschnitte, in denen die Schirmelektrode auf Masse gebracht bzw. die Sensorelektrode über den Referenzkondensator entladen wird. Die Breite 18 der Impulse ist schmaler als die Breite der Impulse bei den Potentialverläufen 10 und 11. In dem Zeitintervall 19 ist eine alternative Ausführungsform angedeutet, bei der die Impulsbreiten der Potentialverläufe 12, 11 und 10 gleich sind, bei dem aber die Impulse der Hintergrundelektrode zeitlich um eine Distanz 20 versetzt auftreten. Dies lässt sich anhand der Zeitreferenzlinie 14 gut erkennen. Trotz dieses geringfügigen Versatzes 20 wird das erfindungsgemäße Ziel der verbesserten räumlichen Sensitivität erreicht.
- 1: Sensorelektrodenanordnung
- 2: Hintergrundelektrode
- 3: Schirmelektrode
- 4: Sensorelektrode
- 5: Steuer- und Auswerteschaltung
- 6: Raum vor der Sensorelektrode
- 7: Versorgungsspannungsanschluss
- 8: Masse
- 10: Potentialverlauf an der Sensorelektrode
- 11: Potentialverlauf an der Schirmelektrode
- 12: Potentialverlauf an der Hintergrundelektrode
- 13: Linie für Schwellenspannungsniveau Uₛ
- 14: Linie für einen bestimmten Zeitpunkt
- 15: Mikrocontroller
- 16: Referenzkondensator
- 17: Zeitintervall, in dem Tastverhältnis geändert
- 18: Impulsbreite
- 19: Zeitintervall, in dem Hintergrundelektrodenansteuerung zeitlich versetzt ist
- 20: zeitlicher Versatz

## Patentansprüche

1. Kapazitive Sensoranordnung mit
einer Sensorelektrode (4), mit deren Hilfe das Eindringen eines Objekts in einen Raum (6) vor der Sensorelektrode (4) erfasst werden soll,
einer mit der Sensorelektrode (4) gekoppelten Steuer- und Auswerteschaltung(5), die eine Änderung der Kapazität der Sensorelektrode (4) gegenüber einem Referenzpotential erfasst, indem sie die Sensorelektrode (4) mit einer vorgegebenen Frequenz periodisch wiederholt mit einem vorgegebenen ersten Potential koppelt und wenigstens einen Parameter eines vom periodischen Laden und Entladen der Sensorelektrode (4) abhängigen Strom- oder Spannungsverlaufs zur Erfassung der Kapazitätsänderung auswertet,
wenigstens einer Hintergrundelektrode (2), die beabstandet hinter der Sensorelektrode (4) angeordnet ist, und
einer Schirmelektrode (3), die zwischen der Sensorelektrode (4) und der wenigstens einen Hintergrundelektrode (2) angeordnet und über die Steuer- und Auswerteschaltung (5) derart mit der Sensorelektrode (4) gekoppelt ist, dass sie keinen Einfluss auf die gegenüber dem Referenzpotential gemessene Kapazität der Sensorelektrode (4) hat und dass ihr Potential dem Potential der Sensorelektrode (4) zumindest in einem Teilabschnitt jeder Periode des Ladens und Entladens der Sensorelektrode nachgeführt wird,
wobei die Hintergrundelektrode (2) oder wenigstens eine der Hintergrundelektroden mit der Steuer- und Auswerteschaltung (5) gekoppelt ist und derart angesteuert wird, dass ihr Potential mit der vorgegebenen Frequenz periodisch zwischen dem Referenzpotential und einem zweiten Potential, das gegenüber dem Referenzpotential dieselbe Polarität wie das erste Potential hat, komplementär zu dem Potential der Sensorelektrode (4) derart umgeschaltet wird, dass die Hintergrundelektrode (2) zumindest während eines überwiegenden Teils derjenigen Zeiten, in denen die Sensorelektrode (4) mit dem ersten Potential gekoppelt wird, auf das Referenzpotential gelegt wird, und zumindest während eines überwiegenden Teils derjenigen Zeiten, in denen die Sensorelektrode (4) nicht mit dem ersten Potential gekoppelt wird, auf das zweite Potential gelegt wird, so dass die Potentialverläufe der Sensor- und der Hintergrundelektrode zeitlich versetzt und/oder mit abweichendem Tastverhältnis umgeschaltet werden können.

2. Kapazitive Sensoranordnung nach Anspruch 1, **dadurch gekennzeichnet, dass** das Referenzpotential Masse (8) ist.

3. Kapazitive Sensoranordnung nach Anspruch 2, **dadurch gekennzeichnet, dass** das erste Potential und das zweite Potential dem Potential einer Versorgungsspannung der Steuer- und Auswerteschaltung (5) gegenüber Masse entsprechen.

4. Kapazitive Sensoranordnung nach einem der Ansprüche 1 - 3, **dadurch gekennzeichnet, dass** die Hintergrundelektrode (2) derart angesteuert wird, dass das Potential der Hintergrundelektrode (2) während derjenigen Zeiten, in denen sich die Sensorelektrode (4) auf dem ersten Potential befindet, auf das Referenzpotential gelegt wird.

5. Kapazitive Sensoranordnung nach einem der Ansprüche 1 - 4, **dadurch gekennzeichnet, dass** die Hintergrundelektrode (2) derart angesteuert wird, dass das Potential der Hintergrundelektrode (2) während derjenigen Zeiten, in denen sich die Sensorelektrode (4) nicht auf dem ersten Potential befindet, auf das zweite Potential gelegt wird.

6. Kapazitive Sensoranordnung nach einem der Ansprüche 1 - 5, **dadurch gekennzeichnet, dass** die Hintergrundelektrode (2) derart angesteuert wird, dass das Potential der Hintergrundelektrode (2) mit dem gleichen Tastverhältnis auf das Referenzpotential geschaltet wird, mit dem die Sensorelektrode (4) auf das erste Potential geschaltet wird.

7. Kapazitive Sensoranordnung nach Anspruch 6, **dadurch gekennzeichnet, dass** das Tastverhältnis 50% beträgt.

8. Kapazitive Sensoranordnung nach einem der Ansprüche 1 - 7, **dadurch gekennzeichnet, dass** die Hintergrundelektrode (2) und die Sensorelektrode (4) synchron und komplementär umgeschaltet werden.

9. Kapazitive Sensoranordnung nach einem der Ansprüche 1 - 8, **dadurch gekennzeichnet, dass** mehrere nebeneinander hinter der Sensorelektrode (4) und der Schirmelektrode (3) angeordnete Hintergrundelektroden (2) vorgesehen sind, von denen eine mit der Steuer- und Auswerteschaltung (5) gekoppelt ist und derart angesteuert wird, dass ihr Potential periodisch mit der vorgegebenen Frequenz zwischen dem Referenzpotential und dem zweiten Potential umgeschaltet wird.

10. Kapazitive Sensoranordnung nach Anspruch 9, **dadurch gekennzeichnet, dass** die übrigen Hintergrundelektroden mit dem Referenzpotential gekoppelt sind.

11. Kapazitive Sensoranordnung nach einem der Ansprüche 1 - 10, **dadurch gekennzeichnet, dass** die vorgegebene Frequenz im Bereich zwischen 50 kHz und 5 MHz, vorzugsweise zwischen 125 kHz und 1 MHz, liegt.

12. Kapazitive Sensoranordnung nach einem der Ansprüche 1 - 11, **dadurch gekennzeichnet, dass** die Sensorelektrode (4), ein mit der Sensorelektrode (4) verbundener Referenzkondensator (16), die Schirmelektrode (3) und die Hintergrundelektrode (2) jeweils mit einem Ausgabe-Port (A - F) eines Mikrocontrollers (15) verbunden sind, wobei der Mikrocontroller (15) Teil der Auswerte- und Steuerschaltung (5) ist und über die Ports (A - F) die Elektroden entweder mit Betriebsspannung oder mit Masse koppeln oder hochohmig entkoppeln kann, so dass der Mikrocontroller (15) programmgesteuert
den Port (A) der Sensorelektrode (4) abwechselnd auf die Betriebsspannung legt und hochohmig entkoppelt,
den Port (B) des Referenzkondensators (16) im Wesentlichen synchron mit dem Port (A) der Sensorelektrode (4) abwechselnd hochohmig entkoppelt und auf Masse legt,
die Schirmelektrode (3) dem Potential der Sensorelektrode (4) nachführt, indem er den Port (C, D) der Schirmelektrode (3) synchron mit dem Port (A) der Sensorelektrode abwechselnd auf die Betriebsspannung und auf Masse legt, und
den Port (E, F) der Hintergrundelektrode (2) zwischen Masse und Betriebsspannung umschaltet, wobei der Port (E, F) der Hintergrundelektrode (2) zumindest während eines Teils derjenigen Zeiten, in denen sich der Port (A) der Sensorelektrode (4) auf Betriebsspannung befindet, auf Masse gelegt wird, und zumindest während eines Teils derjenigen Zeiten, in denen sich der Port (A) der Sensorelektrode (4) nicht auf Betriebsspannung befindet, auf Betriebsspannung gelegt wird.

13. Kapazitive Sensoranordnung nach Anspruch 12, **dadurch gekennzeichnet, dass** der Port (A) der Sensorelektrode (4) zusätzlich einen Eingabe-Port mit einem A/D-Wandler aufweist, der dann aktiviert wird, wenn der Ausgabe-Port hochohmig entkoppelt ist.

## Claims

1. A capacitive sensor arrangement having
a sensor electrode (4), with the aid of which the penetration of an object into a space (6) in front of the sensor electrode (4) should be detected,
a control and analysis circuit (5) coupled to the sensor electrode (4), which detects a change of the capacitance of the sensor electrode (4) compared to a reference potential, in that it periodically repeatedly couples the sensor electrode (4) with a predetermined frequency with a predetermined first potential and analyses at least one parameter of a current or voltage curve dependent on the periodic charging and discharging of the sensor electrode (4) to detect the change in the capacity,
at least one background electrode (2), which is arranged spaced behind the sensor electrode (4), and
a guard electrode (3), which is arranged between the sensor electrode (4) and the at least one background electrode (2) and is coupled via the control and analysis circuit (5) to the sensor electrode (4) in such a manner that it does not have any influence on the capacitance of the sensor electrode (4) measured in comparison with the reference potential and that the potential thereof is updated to the potential of the sensor electrode (4) at least in a portion of each period of charging and discharging of the sensor electrode,
wherein the background electrode (2) or at least one of the background electrodes is coupled with the control and analysis circuit (5) and is controlled in such a manner that the potential thereof is switched periodically with the predetermined frequency between the reference potential and a second potential, which compared to the reference potential has the same polarity as the first potential, complementarily to the potential of the sensor electrode (4) in such a manner that the background electrode (2) is set to the reference potential, at least during the majority of those times, in which the sensor electrode (4) is coupled to the first potential, and is set to the second potential at least during a majority of those times, in which the sensor electrode (4) is not coupled to the first potential, so that the potential curves of the sensor electrode and the background electrode can be temporally offset and/or switched with a deviating duty cycle.

2. The capacitive sensor arrangement according to claim 1, **characterised in that** the reference potential is earth (8).

3. The capacitive sensor arrangement according to claim 2, **characterised in that** the first potential and the second potential correspond to a supply voltage of the control and analysis circuit (5) compared to earth.

4. The capacitive sensor arrangement according to one of claims 1 - 3, **characterised in that** the background electrode (2) is controlled in such a manner that the potential of the background electrode (2) is set to the reference potential during those times, in which the sensor electrode (4) is at the first potential.

5. The capacitive sensor arrangement according to one of claims 1 - 4, **characterised in that** the background electrode (2) is controlled in such a manner that the potential of the background electrode (2) is set to the second potential during those times, in which the sensor electrode (4) is not at the first potential.

6. The capacitive sensor arrangement according to one of claims 1 - 5, **characterised in that** the background electrode (2) is controlled in such a manner that the potential of the background electrode (2) is switched to the reference potential with the same duty cycle with which the sensor electrode (4) is switched to the first potential.

7. The capacitive sensor arrangement according to claim 6, **characterised in that** the duty cycle is 50%.

8. The capacitive sensor arrangement according to one of claims 1 - 7, **characterised in that** the background electrode (2) and the sensor electrode (4) are switched synchronously and complementarily.

9. The capacitive sensor arrangement according to one of claims 1 - 8, **characterised in that** a plurality background electrodes (2) arranged next to one another behind the sensor electrode (4) and the guard electrode (3) are provided, of which one is coupled to the control and analysis circuit (5) and is controlled in such a manner that the potential thereof is periodically switched with the predetermined frequency between the reference potential and the second potential.

10. The capacitive sensor arrangement according to claim 9, **characterised in that** the remaining background electrodes are coupled to the reference potential.

11. The capacitive sensor arrangement according to one of claims 1 - 10, **characterised in that** the predetermined frequency lies in the ranged between 50 kHz and 5 MHz, preferably between 125 kHz and 1 MHz.

12. The capacitive arrangement according to one of claims 1 - 11, **characterised in that** the sensor electrode (4), a reference capacitor (16) connected to the sensor electrode (4), the guard electrode (3) and the background electrode (2) are in each case connected to an output port (A - F) of a microcontroller (15), wherein the microcontroller (15) is part of the analysis and control circuit (5) and the electrodes can couple either with operating voltage or with earth or high-ohmically decouple via the ports (A - F), so that, in a program-controlled manner, the microcontroller (15)
sets the port (A) of the sensor electrode (4) to the operating voltage and high-ohmically decouples the same in an alternating manner,
high-ohmically decouples the port (B) of the reference capacitor (16) and sets the same to earth in an alternating manner, essentially synchronously with the port (A) of the sensor electrode (4),
updates the guard electrode (3) to the potential of the sensor electrode (4), **in that** it sets the port (C, D) of the guard electrode (3) to the operating voltage and to earth in an alternating manner synchronously with the port (A) of the sensor electrode, and
switches the port (E, F) of the background electrode (2) between earth and operating voltage, wherein the port (E, F) of the background electrode (2) is set to earth at least during a portion of those times, in which the port (A) of the sensor electrode (4) is at operating voltage, and is set to operating voltage at least during a portion of those times, in which the port (A) of the sensor electrode (4) is not at operating voltage.

13. The capacitive sensor arrangement according to claim 12, **characterised in that** the port (A) of the sensor electrode (4) additionally has an input port with an A/D converter, which is activated if the output port is high-ohmically decoupled.

## Revendications

1. Agencement de capteur capacitif avec
une électrode de capteur (4), à l'aide de laquelle la pénétration d'un objet dans un espace (6) devant l'électrode de capteur (4) doit être détectée,
un circuit de commande et d'évaluation (5) couplé à l'électrode de capteur (4), lequel détecte une variation de la capacité de l'électrode de capteur (4) par rapport à un potentiel de référence en ce qu'il couple l'électrode de capteur (4), avec une fréquence prescrite de manière répétée périodiquement, à un premier potentiel prédéterminé et évalue au moins un paramètre d'une variation de courant ou de tension dépendant de la charge et décharge périodique de l'électrode de capteur (4) pour la détection de la variation de la capacité,
au moins une électrode d'arrière-plan (2), laquelle est disposée à distance derrière l'électrode de capteur (4), et
une électrode écran (3), laquelle est disposée entre l'électrode de capteur (4) et l'au moins une électrode d'arrière-plan (2) et est couplée par l'intermédiaire du circuit de commande et d'évaluation (5) à l'électrode de capteur (4) de manière à ce qu'elle n'exerce aucune influence sur la capacité de l'électrode de capteur (4) mesurée par rapport au potentiel de référence et que son potentiel soit asservi au potentiel de l'électrode de capteur (4) au moins dans une section partielle de chaque période de charge et de décharge de l'électrode de capteur,
l'électrode d'arrière-plan (2), ou bien au moins l'une des électrodes d'arrière-plan, étant couplée au circuit de commande et d'évaluation (5) et étant commandée de manière à ce que son potentiel soit commuté, de manière complémentaire au potentiel de l'électrode de capteur (4), avec la fréquence prescrite, de manière périodique, entre le potentiel de référence et un deuxième potentiel, lequel possède la même polarité que le premier potentiel compte tenu du potentiel de référence, de manière à ce que l'électrode d'arrière-plan (2), au moins pendant une partie essentielle des temps où l'électrode de capteur (4) est couplée au premier potentiel, est mise au potentiel de référence, et au moins pendant une partie essentielle des temps où l'électrode de capteur (4) n'est pas couplée au premier potentiel, est mise au deuxième potentiel, de sorte que les variations de potentiel des électrodes de capteur et d'arrière-plan puissent être commutées de manière décalée dans le temps et/ou avec un rapport cyclique divergent.

2. Agencement de capteur capacitif selon la revendication 1, **caractérisé en ce que** le potentiel de référence est la masse (8).

3. Agencement de capteur capacitif selon la revendication 2, **caractérisé en ce que** le premier potentiel et le deuxième potentiel correspondent au potentiel d'une tension d'alimentation du circuit de commande et d'évaluation (5) par rapport à la masse.

4. Agencement de capteur capacitif selon l'une des revendications 1 - 3, **caractérisé en ce que** l'électrode d'arrière-plan (2) est commandée de manière à ce que le potentiel de l'électrode d'arrière-plan (2) est mis au potentiel de référence pendant les temps pendant lesquels l'électrode de capteur (4) se trouve au premier potentiel.

5. Agencement de capteur capacitif selon l'une des revendications 1 - 4, **caractérisé en ce que** l'électrode d'arrière-plan (2) est commandée de manière à ce que le potentiel de l'électrode d'arrière-plan (2) soit mis au deuxième potentiel pendant les temps pendant lesquels l'électrode de capteur (4) ne se trouve pas au premier potentiel.

6. Agencement de capteur capacitif selon l'une des revendications 1 - 5, **caractérisé en ce que** l'électrode d'arrière-plan (2) est commandée de manière à ce que le potentiel de l'électrode d'arrière-plan (2) soit commuté au potentiel de référence avec le même rapport cyclique avec lequel l'électrode de capteur (4) est commutée au premier potentiel.

7. Agencement de capteur capacitif selon la revendication 6, **caractérisé en ce que** le rapport cyclique est de 50%.

8. Agencement de capteur capacitif selon l'une des revendications 1 - 7, **caractérisé en ce que** l'électrode d'arrière-plan (2) et l'électrode de capteur (4) sont commutées de manière synchrone et complémentaire.

9. Agencement de capteur capacitif selon l'une des revendications 1 - 8, **caractérisé en ce que** l'on prévoit plusieurs électrodes d'arrière-plan (2) disposées les unes à côté des autres derrière l'électrode de capteur (4) et l'électrode écran (3), l'une d'entre elles étant couplée au circuit de commande et d'évaluation (5) et étant commandée de manière à ce que son potentiel soit commuté périodiquement, avec la fréquence prescrite, entre le potentiel de référence et le deuxième potentiel.

10. Agencement de capteur capacitif selon la revendication 9, **caractérisé en ce que** les autres électrodes d'arrière-plan sont couplées au potentiel de référence.

11. Agencement de capteur capacitif selon l'une des revendications 1 - 10, **caractérisé en ce que** la fréquence prescrite se situe dans la plage comprise entre 50 kHz et 5 MHz, de préférence entre 125 kHz et 1 MHz.

12. Agencement de capteur capacitif selon l'une des revendications 1 - 11, **caractérisé en ce que** l'électrode de capteur (4), un condensateur de référence (16) en liaison avec l'électrode de capteur (4), l'électrode écran (3) et l'électrode d'arrière-plan (2) sont respectivement relié(e)s à un port de sortie (A-F) d'un microcontrôleur (15), le microcontrôleur (15) faisant partie du circuit de commande et d'évaluation (5) et, par l'intermédiaire des ports (A-F), pouvant coupler ou découpler à valeur ohmique élevée les électrodes à une tension de service ou à la masse, de sorte que de manière commandée par programme, le microcontrôleur (15)
met tour à tour le port (A) de l'électrode de capteur (4) à la tension de service et le découple à valeur ohmique élevée,
découple tour à tour à valeur ohmique élevée le port (B) du condensateur de référence (16), sensiblement de manière synchrone avec le port (A) de l'électrode de capteur (4), et le met à la masse,
asservi l'électrode écran (3) au potentiel de l'électrode de capteur (4) en mettant tour à tour le port (C, D) de l'électrode écran (3), de manière synchrone avec le port (A) de l'électrode de capteur, à la tension de service et à la masse, et
commute le port (E, F) de l'électrode d'arrière-plan (2) entre la masse et la tension de service, le port (E, F) de l'électrode d'arrière-plan (2) étant mis à la masse au moins pendant une partie des temps pendant lesquels le port (A) de l'électrode de capteur (4) se trouve à la tension de service, et étant mis à la tension de service au moins pendant une partie des temps pendant lesquels le port (A) de l'électrode de capteur (4) ne se trouve pas à la tension de service.

13. Agencement de capteur capacitif selon la revendication 12, **caractérisé en ce que** le port (A) de l'électrode de capteur (4) présente de manière supplémentaire un port d'entrée avec un convertisseur A/N qui est activé lorsque le port de sortie est découplé à valeur ohmique élevée.
